Europäisches Patentamt

European Patent Office

Office européen des brevets

(11) Veröffentlichungsnummer: **0 471 196 A2**

# (12) EUROPÄISCHE PATENTANMELDUNG

(21) Anmeldenummer: **91111878.4**

(22) Anmeldetag: **16.07.91**

(51) Int. Cl.⁵: **G06F 15/70**

(30) Priorität: **13.08.90 DE 4025623**

(43) Veröffentlichungstag der Anmeldung:
**19.02.92 Patentblatt 92/08**

(84) Benannte Vertragsstaaten:
**CH DE ES FR GB IT LI**

(71) Anmelder: **SIEMENS AKTIENGESELLSCHAFT**
**Wittelsbacherplatz 2**
**W-8000 München 2(DE)**

(72) Erfinder: **Mengel, Peter, Dr.**

EP 0 471 196 A2

Die Erfindung betrifft ein Verfahren zur Bildanalyse, bei dem durch Triangulation ein dreidimensionales Bild aufgenommen wird. Der Dateninhalt dieses Bildes wird durch Extraktion bestimmter Bildmerkmale reduziert. Anhand der extrahierten Bildmerkmale wird eine Klassierung vorgenommen, die auf der Grundlage des Vergleiches mit einem Muster oder idealen Daten ein zu prüfendes Bild in verschiedene Klassen einordnet. Die verschiedenen Klassen sind stellvertretend für beispielsweise die Übereinstimmung des Prüflings mit einem Muster bzw. der Fehlerfreiheit des Prüflings oder für das Vorliegen eines bestimmten Fehlers.

Die industrielle Meß- und Prüftechnik muß aufgrund des starken Wandels in den Montagetechnologien ständig angepaßt werden. Dabei wird der Anspruch auf hohe Flexibilität bei gleichzeitig steigendem Automatisierungsgrad erhoben. Hierzu werden neue Prüfmethoden und Prüfstrategien entwickelt. Visuelle Prüfungen durch den Menschen scheiden dabei aufgrund der begrenzten Prüfsicherheit und aufgrund des personellen Aufwands zunehmend aus. In der Automatisierung der Verfahren gewinnt dabei die Rückkoppelung der Prüfdaten zur Regelung beispielsweise der Fertigungsprozesse zunehmend an Bedeutung. Das erklärte Ziel dabei ist eine ganzheitliche Betrachtung aller aufeinander wirkenden Prozesse, sowie ihre Wechselbeziehungen untereinander bis zum Endprodukt hin zu verfolgen.

Insbesondere bei der Herstellung von bestückten Leiterplatten, sogenannten Flachbaugruppen, sind Prüfverfahren erforderlich, die komplexe Aufgaben bei gleichzeitig flexiblem Einsatz bewältigen müssen. Die Anforderungen bestehen insbesondere in einer sicheren Erkennung aller vorkommenden Fehler, in einer hohen Prüfgeschwindigkeit, sowie in einer automatischen Generierung von Prüfprogrammen. Für eine sichere Erkennung ist ein hohes Auflösevermögen optisch arbeitender Prüfverfahren notwendig. Eine hohe Prüfgeschwindigkeit ermöglicht die Synchronisierung der Prüfung mit den vorgeschalteten Fertigungsverfahren. Eine automatische Generierung von Prüfprogrammen kann beispielsweise auf der Grundlage von CAD-CAM-Daten geschehen.

Als visuelle und automatisierbare Prüfverfahren kommen prinzipiell die optische Graubildverarbeitung, die optische 3D-Sensorik mit Laser-Scanner, die Röntgentechnik und die thermische Laserimpuls-Infrotmethode in Frage. Dabei hat jedes Verfahren für sich besondere Vorteile. Trotzdem stößt beispielsweise die Grauwertbildverarbeitung bei wechselnden Lichtintensitäten am zu prüfenden Objekt bei einem Dynamikbereich von 1:500 an ihre Grenzen.

Die in der Fertigung von Flachbaugruppen überwiegend eingesetzte optische 3D-Sensorik ermöglicht die direkte Bestimmung der Oberflächenkoordinaten einer Vielzahl von Punkten auf der Oberfläche einer Flachbaugruppe. Das hierzu verwendete Verfahren der Triangulation basiert auf der diffusen Reflexion eines Lichtstrahles. Die besonderen Vorteile dieses Verfahrens sind die weitreichenden Aussagen bezüglich der Form, der Position und der räumlichen Orientierung der Bestückkomponenten auf einer Flachbaugruppe. Man erhält hier ein dreidimensionales Rasterbild. Neben einer zuverlässigen und kontrastunabhängigen Trennung der Bestückkomponenten vom Hintergrund der Leiterplatte erlaubt ein dreidimensionales Bild dieser Art die Ableitung von globalen geometrischen Daten, die zur Reduzierung der Bilddaten durch Extraktion bestimmter Bildmerkmale herangezogen werden können. Hier sind Maxima, Volumina, Form und Neigung von Oberflächen zu nennen. Da bei einer Flachbaugruppe, die mit verschiedensten elektronischen Bauelementen bestückt ist, nicht nur die Bauelemente ansich, sondern auch die Lötstellen geprüft werden sollen, muß erneut die Sicherheit des Verfahrens bei der Bearbeitung von teilweise reflektierenden Oberflächen betrachtet werden. In diesem Zusammenhang ist es bekannt, die 3D-Bildaufnahme mittels Triangulation durch die Aufnahme eines Grauwertes mittels einer Fotodiode zu unterstützen, wobei im Stand der Technik jedoch lediglich eine Nachregelung des Meßstrahles (Laserstrahl) für jeden aktuell abgetasteten Punkt vorgenommen wird.

Der Erfindung liegt die Aufgabe zugrunde, die Erkennungssicherheit bei der Bildanalyse mittels dreidimensionaler Bildaufnahme zu erhöhen, damit auch reflektierende Oberflächen mit hoher Sicherheit geprüft und klassiert werden können.

Die Lösung dieser Aufgabe wird durch die Merkmale des Anspruches 1 wiedergegeben.

Der Erfindung liegt die Erkenntnis zugrunde, daß die Erkennungssicherheit bei der Bildanalyse, deren Bildaufnahme auf der Triangulation basiert und die eine Klassierung anhand von extrahierten Bildmerkmalen durchführt, durch die gleichzeitige Verarbeitung von Bildmerkmalen aus dem Grauwertbild wesentlich erhöht werden kann. Hierbei wird neben den Bildmerkmalen aus dem Höhenbild zusätzlich aus dem Grauwertbild eine bestimmte Anzahl von Bildmerkmalen extrahiert und die Summe aller Bildmerkmale zur Klassierung eines Bildes herangezogen. Somit lassen sich bestimmte Teile eines Prüflings, die aus dem aufgenommenen Höhenbild nicht eindeutig zu identifizieren sind, mittels der zusätzlich auswertbaren Bildmerkmale ableiten.

Es ist besonders vorteilhaft, die aus dem Grauwertbild extrahierten Bildmerkmale zu einer Plausibilitätsprüfung heranzuziehen. Die für einen bestimmten Punkt oder Bereich aus dem Höhenbild zu entnehmende

2

Information in Form eines Bildmerkmales wird mit der korrespondierenden, d. h. auf den gleichen Ort bezogenen Information aus dem Grauwertbild verglichen. Dieser Vergleich erhöht die Meßsicherheit durch die Ausschaltung von Fehlinterpretationen aus lediglich einem Bild, dem Höhenbild oder dem Grauwertbild. Da korrespondierende Bildmerkmale aus dem Höhenbild und dem Grauwertbild logischerweise die gleichen Teile der Oberfläche wiedergeben, muß die Aussage aus jedem der beiden Bilder korrelieren.

Zur Ausschaltung von nachteiligen Reflexionen auf einem zu prüfenden Objekt können die Reflektionseigenschaften des Objektes durch eine Betauung einheitlich vermindert werden. Hierzu wird in einfacher Weise zerstäubtes Wasser mit einem Luftstrom verdunstet und auf die aktuell geprüfte Stelle geleitet, wobei durch die Prozeßführung oder -Regelung eine Betauung, d. h. eine Kondensation des Wassers auf der Oberfläche des Objektes erzielt wird.

Eine weitere Ausgestaltung der Erfindung erhöht ebenfalls die Erkennungssicherheit und besteht aus der Messung durch Triangulation aus zwei gegenüberliegenden Seiten oder Richtungen bezüglich des gleichen zu messenden Punktes. Diese Anordnung ist zweckmäßigerweise spiegelsymmetrisch zu einem messenden Lichtstrahl, der in der Regel senkrecht auf der Objektoberfläche steht, ausgebildet. Hierdurch werden Abschattungen, die durch Kanten bei einseitiger Detektion der 3D-Höhendaten auftauchen, vermieden.

Im folgenden wird anhand der schematischen Figur ein Ausführungsbeispiel beschrieben.

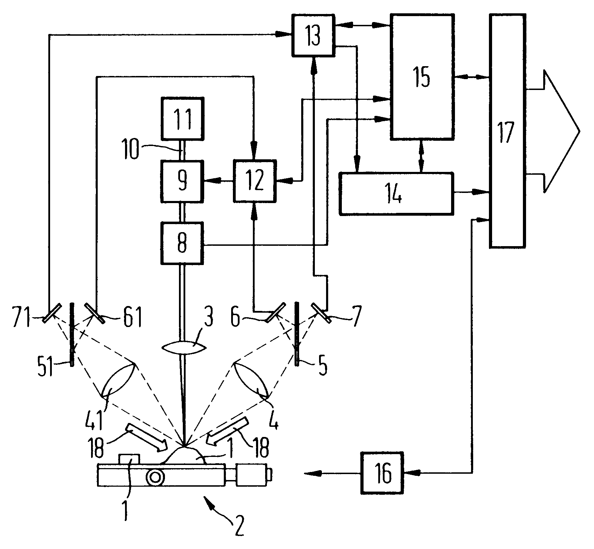

Die Figur zeigt einen X/Y-Tisch 2 mit verschiedenartigen Testobjekten 1. Mittels der Ansteuerung 16 des X/Y-Tisches 2 ist dieser rasterartig verfahrbar und das gesamte System kennt gleichzeitig die X, Y-Koordinaten des aktuell zu prüfenden Fensters auf einer Flachbaugruppe. In der Regel wird für das Anwendungsgebiet der Bildanalyse und der Prüfung an elektronischen Flachbaugruppen die Triangulation mittels eines Lasers durchgeführt. In der Figur wird zur Erzeugung des Laserstrahles 10 der Laser 11 eingesetzt, wobei ein Modulator 9 und ein Schwingspiegel 8, sowie ein Scan-Objektiv 3 nachgeschaltet sind. Die Fenster werden rasterartig auf der Flachbaugruppe verschoben und innerhalb eines momentan feststehenden Fensters wird jeweils durch den abgelenkten Laserstrahl 10 eine hohe Anzahl von Bildpunkten bzw. Oberflächenpunkten scannend aufgenommen. Die Bildaufnahme geschieht über positionsempfindliche Detektoren, sogenannte Positionssensoren 7, 71. Die am Testobjekt 1 diffus gestreute Strahlung wird über Objektive 4, 41 auf die Positionssensoren 7, 71 geleitet, die ihrerseits nach optoelektronischer Wandlung ein elektrisches Signal an eine Sensorkopplung 13 weitergeben. Diese Sensorkopplung 13 führt gleichzeitig die Digitalisierung der Signale durch.

Wie in der Figur dargestellt ist die Anordnung der Positionssensoren zweifach ausgeführt, so daß Abschattungen durch Bauteilkanten auf dem Testobjekt nicht zu Fehlmessungen führen. Die Betauung 18 ist durch Pfeile angedeutet. Zweckmäßigerweise ist sie mit dem apparativen Aufbau der Lasertriangulationseinheit verbunden, so daß nur das aktuell abgetastete Fenster auf der Flachbaugruppe betaut wird.

Über zwei Strahlteiler 5, 51 kann ein Teil des reflektierten Lichtes auf die Fotodetektoren 6, 61 geleitet werden. Nach optoelektronischen Wandlung wird das daraus erhaltene Signal auf den Regler 12 geführt, der den Modulator 9 entsprechend regelt. Gleichzeitig sind der Regler 12 und der Schwingspiegel 8 direkt mit der Ablaufsteuerung 15 verbunden.

Die Organisation der Koordinaten wird durch die Koordinatenauswertung 14 vorgenommen. Die Daten der Ablaufsteuerung 15, der Koordinatenauswertung 14 und der Ansteuerung 16 des X/Y-Tisches werden insgesamt über ein Interface 17 einem Rechner zugeführt.

Zur näheren Erläuterung des erfindungsgemäßen Verfahrens werden nochmals die einzelnen Verfahrensschritte in ihrer Reihenfolge aufgeführt:
Ein Testobjekt 1 wird mittels der Lasertriangulation unter Einsatz eines Scanners abgetastet, bildhaft aufgenommen und gespeichert. Zu diesem Zeitpunkt liegen die digitalen Bilddaten in Form eines Höhenbildes und in Form eines Grauwertbildes vor. Gleichzeitig ist der Zugriff auf CAD/CAM-Daten möglich. An dieser Stelle können bereits Plausibilitätskontrollen zwischen dem dreidimensionalen Höhenbild und dem zweidimensionalen Grauwertbild erfolgen. Nach der Extraktion der Bildmerkmale werden ebenfalls Plausibilitätsvergleiche zwischen den beiden Bildern angestellt, die sich jetzt jedoch auf konkrete Bildinhalte beziehen. Im nächsten Schritt wird die endgültige Analyse mit der Verkettung der verschiedenen Bilderkennungsoperationen durchgeführt. Dabei kann beispielsweise die Darstellung einer gleichbleibenden Höhe oder einer unterschiedlichen Oberflächenstruktur im dreidimensionalen Höhenbild unter Umständen nicht aufgrund der aufgenommenen Meßdaten durchgeführt werden. Hierzu dienen die zusätzlich gleichzeitig aufgenommenen und auch gleichzeitig mitverarbeiteten zweidimensionalen Aussagen aus dem Grauwertbild. Somit können Fehlinformationen herausgefiltert werden. Diese Form der Bildanalyse, die auf Grauwert- und Höheninformationen aufbaut und mit globalen Mustererkennungsoperationen verbunden ist, stützt sich demnach auf eine assoziative Auswertung.

Somit kann neben der bisher durch Lasertriangulationsverfahren mit gutem Ergebnis durchgeführten

3

Bestückungsprüfung auch die Prüfung von Lötstellen auf einer bestückten Leiterplatte mit hoher Erkennungsgenauigkeit von Fehlern und geringer Alarmrate (Fehlermeldung bei ansich guten Lötstellen) durchgeführt werden.

Zu erkennen sind beispielsweise:

- Lotbrücken
- Anschluß nicht sichtbar
- Anschluß nicht benetzt
- Lotumfließung unvollständig
- Lotzapfen größer als vorgegeben
- Lotkugel oder Lotperle
- Ausbläser

Es können prinzipiell Lötstellen an bedrahteten Bauelementen, an schwallgelöteten Oberflächenbauelementen (SMD) und an reflow-gelöteten SMDs geprüft werden. Eine zusätzliche Erkennungsoperation ist dabei die Bestimmung der Oberflächeneigenschaften eines Testobjektes 1. Defekte wie beispielsweise ein fehlerhaft hochstehendes Bauelement (Tombstoneeffekt) werden zuverlässig erkannt.

Der Dynamikbereich eines beschriebenen Verfahrens ist mit Sicherheit größer als 1:2000. Dies beruht auf den Maßnahmen, die zur Reduzierung von Stör- und Mehrfachreflexionen getroffen wurden.

Eine Einbindung des Verfahrens in den Material- und Informationsfluß der Fertigung erfolgt über geeignete Kommunikationsschnittstellen. Stehen beispielsweise keine CAD-Daten zur Verfügung, so kann auch auf Musterbaugruppen zurückgegriffen werden, deren Daten im "Teach-In-Verfahren" an das Bilderkennungssystem übertragen werden.

Technische Daten eines Bilderkennungsautomaten:

## Flachbaugruppe im Europaformat:

| | |
|---|---|
| Gesamtinhalt der aufgenommenen Information | 15 MByte |
| reduzierter Inhalt der Prüfinformation | 20 kByte |
| Sensorauflösung | 70 µm |
| Gesamtprüfzeit | 30 sek |
| digitalisierte Höhen- und Grauwertdaten | 8 Bit |
| Abtastrate | 200 kHz |
| Erkennungssicherheit | größer 96 % |
| Fehlmeldungen | kleiner 0,3 % (3000 ppm) |

**Patentansprüche**

1. Verfahren zur Bildanalyse eines mittels Triangulation dreidimensional aufgenommenen und digitalisierten Höhenbildes unter Verwendung einer anhand von extrahierten Bildmerkmalen durchgeführten Klassierung, insbesondere zur visuellen automatischen Inspektion von Lötstellen an bestückten Leiterplatten, wobei gleichzeitig ein zweidimensionales Grauwertbild in digitalisierter Form aufgenommen wird und für jeden zu verarbeitenden Bildpunkt die korrespondierenden Werte des Höhenbildes und des Grauwertbildes gleichzeitig in die Extraktion der Bildmerkmale eingehen.

2. Verfahren nach Anspruch 1, **dadurch gekennzeichnet**, daß aus dem Grauwertbild extrahierte Bildmerkmale zur Prüfung der Plausibilität in Bezug auf korrespondierende Bildmerkmale aus dem Höhenbild eingesetzt werden.

3. Verfahren nach einem der vorhergehenden Ansprüche, **dadurch gekennzeichnet**, daß mittels einer

4

Betauungseinrichtung ein zu prüfendes Objekt zur Vergleichmäßigung der Reflektionseigenschaften oberflächlich betaut wird.

4. Verfahren nach Anspruch 3, **dadurch gekennzeichnet**, daß zur Betauung ein nahezu wassergesättigter Luftstrom verwendet wird.

5. Verfahren nach einem der vorhergehenden Ansprüche, **dadurch gekennzeichnet**, daß die Bildaufnahme mittels Triangulation zweifach und spiegelsymmetrisch in Bezug auf einen messenden Lichtstrahl ausgebildet ist.